# EUROPEAN PATENT SPECIFICATION

(11) **EP 0 296 804 B1**
(45) Date of publication and mention of the grant of the patent: **30.03.1994**
(21) Application number: 88305650.9
(22) Date of filing: 21.06.1988
(51) Int. Cl.: C30B 25/02, C30B 29/06

(54) **Process for epitaxial deposition of silicone**
Verfahren zur Epitaxieabscheidung von Silizium
Procédé pour le dépôt épitaxial de silicium

(30) Priority: 24.06.1987 US 65945; 15.10.1987 US 108771; 14.03.1988 US 167347
(43) Date of publication of application: 28.12.1988
(73) Proprietor: ADVANCED SEMICONDUCTOR MATERIALS AMERICA, INC., Phoenix, Arizona 85034 (US)
(72) Inventor: Goodwin, Dennis Lee, Tempe, Arizona 85282 (US); Hawkins, Mark Richard, Mesa, Arizona 85202 (US); Johnson, Wayne L., Phoenix, Arizona 85044 (US); Olsen, Aage, Chandler, Arizona 85202 (US); Robinson, McDonald, Paradise Valley, Arizona 85253 (US)
(74) Representative: Downey, William Gerrard

(56) References cited:
- US-A- 3 177 100
- US-A- 3 424 629
- MICROELECTRONICS JOURNAL, vol. 9, no. 2, December 1978, pages 8-12, Mackintosh Publications Ltd, Luton, GB; K. DAS et al.: "A small scale silicon epitacial film deposition system"

## Description

### Related Applications

This invention relates to the epitaxial deposition reactor disclosed in a U.S. patent application filed October 15, 1987 as Serial No. 108,771 by R. Crabb et al, entitled "Chemical Vapor Deposition System" and a U.S. application filed June 24, 1987 as Serial No. 065945 by Albert Ozias, entitled "Improved Reaction Chamber for Chemical Vapor Deposition systems.

### Background of the Invention

The present invention relates to a process for epitaxial deposition of silicon. More particularly, the present invention relates to a high throughput single crystal epitaxial deposition process which achieves increased uniformity, both wafer to wafer and across the wafer surface.

Conventional epitaxial processes are characterized by cycle times on the order of 30-60 minutes. As illustrated by U.S. Patent No. 3,177,100 entitled "Depositing Epitaxial Layer of Silicon from a vapor mixture of SiH₄ and H₂" issued to A. Mayer et al, the lengthy cycle time of conventional processes is due, in principal, to the need for protracted cooling prior to removal of the wafer after the deposition reaction. Further delay is occasioned by the consequent requirement of re-heating the susceptor to initiate the subsequent deposition cycle. Repetitive changes in the temperature of the susceptor between each cycle result from the need to cool the susceptor prior to removal from the reaction chamber. It is well known that these temperature changes impart physical stresses which devitrify the crystal lattice in both the susceptor and the substrate. Discontinuities and flaking may also result and further interfere with achieving uniform deposition.

Throughput is, of course, limited by the long cycle times. Because the conventional processes are plagued by low throughput and long cycle times, reactor cleaning is performed only after the deposition runs are complete and the reactor may be taken out of service.

Epitaxial layers on semiconductor wafers have been fabricated by forming a halogen compound of the semiconductor, such as geranium, silicon, or the like, then passing its vapors into a reaction chamber and reducing the halogen with hydrogen. As illustrated in Patent No. 3,177,100, conventional processes position the wafer on a susceptor within the reaction vessel; after evacuation, the reaction chamber is purged with hydrogen and the susceptor and wafer are heated to about 1200° C by rf induction. This temperature is maintained for about fifteen minutes in the flowing hydrogen ambient to clean the wafer surface of any residual oxides. Electrical power to the rf coil is then reduces, thereby reducing the temperature of the wafer and susceptor to within the range of about 1000° C to 1150° C. Silane, SiH₄, mixed with hydrogen is then introduced into the reaction chamber. Decomposition of silane in accordance with the equation:

SiH₄ → Si + 2H₂

which deposits an epitaxial layer of silicon on the wafer. The rate of deposition depends, of course, upon the concentration of silane in the reaction vessel and the temperature of the susceptor. Since the deposition rate is temperature dependant, it is important that the wafer be exposed to substantially uniform temperature profile during the deposition run. N or P doping of the silicon may be achieved by incorporating the dopant into the reactant gas flow.

Alternative conventional processes are described by E.O. Ernst et al in U.S. Patent No. 3,424,629 entitled "High Capacity Epitaxial Apparatus and Method" and by V.Y. Doo and E.O. Ernst in "A Survey of Epitaxial Growth Processes and Equipment," SCP and SOLID STATE TECHNOLOGY, Oct., 1967, pp 31-39. One alternative process utilizes silicon tetrachloride, SiCl₄, as the reactant species in a hydrogen flow. Silicon tetrachloride decomposes according to the following reaction:

SiCl₄ + 2H₂ → Si + 4 HCl

which may produce side reaction products depending upon reactant concentration, temperature, pressure and reactor geometry. This process is characterized by virtually identical time, temperature and pressure profiles as the reaction process with silane.

A summary of the deposition run cycle is provided in United States Patent No. 3,424,629 as follows:
1) Wafers loaded into the reaction chamber;
2) Argon purge at 10 standard liters/minute (slm) for 9 minutes (min.);
3) Hydrogen purge at 25 slm for 10 min.;
4) Rf heating of susceptor to 1200°C;
5) Hydrogen etch for 15 min. to remove oxides;
6) Silicon deposition for 6-14 min., depending upon thickness specification at a deposition rate of 0.8 x 10⁻⁶m/min.
7) Maintain wafer temperature at 1200° C for 3 min.
8) Hydrogen purge;
9) Cool wafers in hydrogen for 10 min.;
10) Cool wafers in argon until wafers reach room temperature for handling;
11) Remove wafers from reactor.

The total running time for a typical run was seventy five minutes. Other reactant species, such as SiHCll₃, SiCl₂ or similar halogenated silicon compounds, may be employed.

It will, therefore, be appreciated by those skilled in the art that protracted deposition run cycle times are characteristic of the conventional epitaxial deposition processes. Factors contributing to the long cycle times include the need to cool the wafers to room temperature prior to handling and the corresponding need to re-heat the reaction chamber for a subsequent deposition run.

Thus, it has been found that a new process was required to alleviate these limitations of the conventional processes. The epitaxial deposition process of the present invention employs low-level cooling periods in order to minimise temperature changes between deposition cycles and intercycle cleaning so that each new wafer is presented with a substantially equivalent deposition environment. By limiting the need for lengthy cool down, providing for inter-cycle cleaning and modulating gas usage, the process of the present invention achieves higher single crystal epi (the word epi is an abbreviation of the word epitaxial which is a term well known in the semiconductor art as meaning single crystal growth of semiconductor material on an underlying semiconductor surface or substrate) growth rates that the conventional processes. The single crystal produced thereby is characterized by a more uniform crystal lattice in each wafer and wafer-to-wafer.

### Summary of the Invention

Thus, it is an object of the present invention to provide a process for epitaxial deposition of silicon which results in shorter deposition cycle times that the conventional processes.

It is a further object of the present invention to provide a process for epitaxial deposition of silicon which reduces temperature changes in the susceptor and in the wafer during the cool down period prior to removal from the reactor.

It is still a further object of the present invention to provide a process for epitaxial deposition of silicon which employs inter-cycle reactor cleaning.

It is another further object of the present invention to provide a process for epitaxial deposition of silicon which achieves higher growth rates than that achieved by the conventional processes.

These and other objects hereinafter disclosed will become more apparent to those skilled in the art from the following more detailed description of the preferred embodiment of the present invention. In the accompanying drawings like features are identified by like reference numerals.

### Brief Description of the Drawings

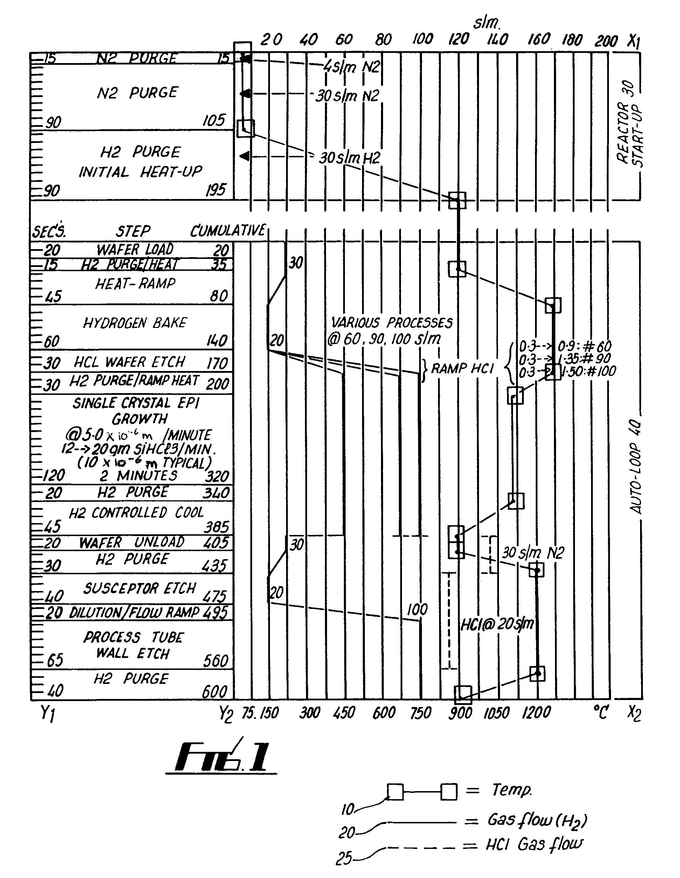

Figure 1 is a process flow diagram of the deposition process cycle of the present invention, showing an X₁-axis thereof the step time, on an X₂-axis thereof the cumulative cycle time, on the Y₁-axis thereof showing gas usage and on the Y₂-axis thereof showing temperature.

### Detailed Description of the Preferred Embodiment

According to the present invention there is provided a process for successive repetitive cycles of epitaxial deposition of silicon in a deposition chamber of a reaction chamber containing a heated susceptor, comprising the steps of:
maintaining said heated susceptor at temperatures above 600°C during and between each of said successive repetitive cycles;
loading a semiconductor substrate onto said heated susceptor at a loading temperature within the range of about 600°C to 1000°C;
heating said susceptor and said substrate to a temperature above said loading temperature;
flowing a gaseous stream of a reactant semiconductor species into said reaction chamber to achieve epitaxial growth of said reactant semiconductor species on said semiconductor substrate;
cooling said susceptor and said substrate;
unloading said semiconductor substrate having said reactant species deposited thereon from said heated susceptor and said deposition chamber into a non-oxidizing environment and in an interlock region to permit the cooling of said semiconductor substrate; and
cleaning said susceptor and said deposition chamber between successive epitaxial deposition cycles.

The present process relates to a single-wafer process which exposes each wafer to substantially identical reaction environments run to run. After deposition in a reactor such as that disclosed in the U.S. Applications by R.Crabb et al, Serial No. 108771, and Albert Ozias, Serial No.065945, a controlled low-grade cooling of the reaction chamber is conducted and the reacted wafer removed. After removal of the reacted wafer from the susceptor and the reaction chamber it is transferred to an interlock for cooling in a non-oxidizing environment of nitrogen or hydrogen. While the reacted wafer is cooling, the epitaxial reactor is re-heated for a susceptor etch and a subsequent chamber etch. After cleaning the susceptor and chamber, the reaction chamber is again subjected to a low-grade cooling for loading of another wafer for a subsequent deposition run.

This process permits both unloading and loading of wafers while the reaction chamber and susceptor are at an elevated temperature. Introduction of the wafer into the heated reaction chamber minimizes the power required to elevate the chamber to deposition temperatures. Unloading of the wafers at an elevated temperature and controlled cooling in an interlock minimizes thermal stresses and crystal lattice devitrification of the deposited epitaxial layer and underlying substrate. Decreased cycle times are an additional benefit derived from isolating the reaction chamber from the wafer handling area.

Moreover, inter-cycle etching of both the susceptor and reaction chamber has been found to equalize the reaction environment to which each wafer is exposed. Greater deposition uniformity, both wafer to wafer and across each wafer, has been found when deposition is carried out according to the present invention. Furthermore, substantial reductions in cycle time, gas usage and power usage have been achieved by the present process.

A preferred embodiment of the present process is illustrated in the accompanying Figure 1. It will be understood by those skilled in the art that the process profiles illustrated by the preferred embodiment are exemplary in nature, and are not intended to be, nor should they be construed to be, limiting of the scope of the present invention. Rather, it is the sequence of steps in the process which provides, in significant part, the advantages of the present process over known epi processes. In Figure 1, temperature 10, H₂ flow 20 and HCl flow 25 are depicted according to the designations set forth in Figure 1.

Daily reactor start-up procedures 30 include purging the reactor with nitrogen flowing at 4 slm for fifteen seconds, followed by a nitrogen purge with 30 slm N₂ for ninety seconds. The chamber is then purged of nitrogen, by flowing hydrogen into the chamber at 30 slm for a period of ninety seconds. During the hydrogen purge initial rf-heating raises the susceptor temperature from about 50° C to about 900° C. It has been found, according to the preferred embodiment of the present invention, that initial heating is best achieved by an initial application of power, followed by alternating power reduction and application of gradually diminishing magnitude. By fluctuating power usage during the initial heating of the reactor, a more uniform temperature gradient is established in the reaction chamber and susceptor.

After reactor start-up 30 is complete, the reactor is run in its auto-loop mode 40, which continuously cycles wafers through the deposition process until the daily run is complete.

A wafer, which has been preferably been pre-loaded into the interlock disclosed in the application R. Crabb et al, Serial No. 108,771, is loaded onto the susceptor at 900° C. After a hydrogen purge at 30 slm for fifteen seconds, the wafer and susceptor are exposed to a forty-five second heat ramp which increases their temperature from 900° C to 1190° C. Again, a uniform temperature increase is achieved by fluctuating power to the rf coils. A sixty second hydrogen bake under 20 slm hydrogen is employed, after which the wafer is etched with HCl for a period of thirty seconds to eliminate semiconductor oxides from the wafer surface.

After wafer etching, the chamber is purged with hydrogen while power is reduced to lower the temperature of the susceptor and wafer from 1190°C to 1135°C in thirty seconds. With the HCl gas flow continuing, SiHCl₃ is introduced into the reactor at a rate of about 12-20 g/min. Single crystal epitaxial growth proceeds at a rate of about 5.0 x 10⁻⁶m/min. Epitaxial growth is conducted for a period of time until thickness is at specification. Experimental testing conducted epitaxial growth for two minutes which grew 10 of single crystal silicon.

The deposition reaction is halted by purging the reaction chamber with hydrogen for twenty-seconds and the wafer and susceptor are cooled from 1130°C to 900°C in a hydrogen atmosphere for forty seconds. When the wafer has reached 900° it is removed from the susceptor and unloaded from the reaction chamber to the interlock. After the wafer is unloaded from the reaction chamber, the chamber is sealed thereby isolating the reaction chamber from the wafer handling area. After the wafer is unloaded from the reaction chamber, the chamber is purged with hydrogen, to which a high flow of an etchant gas, such as HCl, is added at about 20 slm, to the hydrogen carrier flow for a susceptor etch. After the susceptor etch, a dilution/flow ramp is established whereby the HCl flow is continued and hydrogen flow is increased from 20 slm to 100 slm over twenty seconds to etch the reactor chamber of accumulated residues. After cleaning the susceptor and reactor, the reactor is purged with hydrogen at 100 slm.

The final hydrogen purge at 100 slm is the final step of the run cycle and prepares the reactor for a subsequent deposition run and the repetition of auto loop 40. Epitaxial deposition of silicon carried out in accordance with the present invention offers greater thickness and resistivity uniformity. The following example is for illustrative purposes, and is not intended to limit the present invention.

In the processing of over 2,000 150 mm wafers in accordance with the inventive process and in the epitaxial reactors disclosed in the U.S. patent applications by R. Crabb et al, Serial No. 108,771, and Albert Ozias, Serial No. 065945, as heretofore described, substantial uniformity of the crystal lattice has been achieved. In particular, P+ substrates (i.e. substrates heavily doped with p-type impurities) were 100% slip free, while N+ substrates (i.e. substrates heavily doped with n-type impurities) were mostly slip free with slip lines restricted to an outer 3 mm exclusionary zone on the substrate.

The efficacy of the inventive process, and in particular the high-temperature wafer handling and inter-cycle etching, was examined with reference to run-to-run uniformity and uniformity across the wafer surface. Run-to-run uniformity was examined by comparing thickness variations on a run-to-run basis. Fifty runs were examined and thickness variations were limited to between about ± 0.9% to ± 1.6% over the entire fifty runs. Resistivity and thickness variations from a single run was also measured. Resistivity was measured at varying distances from the center of the wafer and varied by no more than ± 1.5%. Similarly, thickness variations across the wafer surface were also measured at varying distances from the centre of the wafer and wafer thickness varied by no more than ± 1.4%.

When the dual-height reaction chamber disclosed in the U.S. patent application by Albert Ozias, Serial No. 065945, was used with the present process, depletion of the reactants from the reactant gas flow was maintained at about ≦ 20% across the wafer surface with increase growth rates. Thus, reactant depletion was kept within that achieved by conventional reactors, but with increased epitaxial growth rates. Furthermore, a significant reduction in wall deposits was noted, thereby rendering inter-cycle etchings feasible. It will be appreciated, by those skilled in the art, that the increased epitaxial growth rate, coupled with the high throughput capabilities and maintenance of a constant run-to-run environment, as achieved by the present process, represent an important advancement in the art of epitaxial deposition.

## Claims

1. A process for successive repetitive cycles of epitaxial deposition of silicon in a deposition chamber of a reaction chamber containing a heated susceptor, comprising the steps of:
maintaining said heated susceptor at temperatures above 600°C during and between each of said successive repetitive cycles;
loading a semiconductor substrate onto said heated susceptor at a loading temperature within the range of about 600°C to 1000°C;
heating said susceptor and said substrate to a temperature above said loading temperature;
flowing a gaseous stream of a reactant semiconductor species into said reaction chamber to achieve epitaxial growth of said reactant semiconductor species on said semiconductor substrate;
cooling said susceptor and said substrate;
unloading said semiconductor substrate having said reactant species deposited thereon from said heated susceptor and said deposition chamber into a non-oxidizing environment and in an interlock region to permit the cooling of said semiconductor substrate; and
cleaning said susceptor and said deposition chamber between successive epitaxial deposition cycles.

2. The process according to Claim 1, wherein cleaning said susceptor and said deposition chamber includes the step of introducing a gaseous etchant into said deposition chamber between said repetitive cycles in order to remove any of said reactant semiconductor species deposited on said susceptor and said deposition chamber.

3. The process according to Claim 1, wherein said step of maintaining said heated susceptor at temperatures above 600°C including the step of heating the susceptor and substrate to a temperature in the range of about 1150°C to about 1200°C.

4. The process according to Claim 1, including the step of etching the semiconductor substrate with an etchant gas to remove impurities from said semiconductor substrate by flowing HCl doped hydrogen gas across the semiconductor susbtrate at a rate of about 60 to about 100 standard litres per minute.

5. The process according to Claim 4, wherein said step of etching the substrate further comprises the step of providing hydrogen gas having about 0.3 to about 1.5 volume percent HCl doped therein.

6. The process according to Claim 1, wherein said step of flowing a gaseous stream of a reactant semiconductor species into the deposition chamber further comprises the step of flowing SiHCl₃ into the deposition chamber and across the semiconductor substrate surface.

7. The process according to Claim 6, wherein said step of flowing SiHCl₃ into the deposition chamber further comprises the step of flowing SiHCl₃ into the deposition chamber at a rate of about 12 to about 20 g/minute.

8. The process according to Claim 1, further comprising the steps of:
sealing the deposition chamber from a semiconductor substrate handling area of the reaction chamber;
flowing an etchant gas into the deposition chamber in a carrier gas while heating the deposition chamber to a temperature greater than the deposition temperature;
etching said susceptor and said deposition chamber with said etchant gas to remove substantially all reactant semiconductor species deposited thereupon; and
purging the deposition chamber of ambient etchant gas while simultaneously cooling the susceptor and deposition chamber thereby preparing the deposition chamber for a subsequent deposition run.

9. The process according to Claim 8, wherein said step of flowing an etchant gas further comprises the step of flowing HCl doped hydrogen gas into the deposition chamber at a rate of about 20 standard litres per minute.

10. The process according to Claim 9, wherein said step of etching said susceptor and the deposition chamber further comprises the step of providing hydrogen gas having about 0.3 to about 1.5 volume percent HCl doped therein.

11. The process according to Claim 10, wherein said step of flowing an etchant gas further comprises the steps of etching said susceptor with HCl doped hydrogen gas flowing at about 20 standard litres per minute, and thereafter, increasing the flow HCl doped hydrogen gas to about 100 standard litres per minute to etch the deposition chamber.

## Patentansprüche

1. Verfahren für aufeinanderfolgende, sich wiederholende Zyklen der Epitaxieabscheidung von Silicium in einer Abscheidungskammer einer Reaktionskammer, die einen beheizten Suszeptor enthält, umfassend die Schritte, daß:
- der beheizte Suszeptor während und zwischen jedem der aufeinanderfolgenden, sich wiederholenden Zyklen bei Temperaturen oberhalb von 600°C gehalten wird;
- ein Halbleitersubstrat auf dem beheizten Suszeptor bei einer Beschickungstemeperatur im Bereich von etwa 600°C bis 1000°C beschickt wird;
- der Suszeptor und das Substrat auf eine Temperatur oberhalb von der Beschickungstemperatur aufgeheizt werden;
- ein Gasstrom einer Reaktand-Halbleitersorte in die Reaktionskammer strömt, um ein epitaktisches Aufwachsen der Reaktand-Halbleitersorte auf dem Halbleitersubstrat auszuführen;
- der Suszeptor und das Substrat gekühlt werden;
- das Halbleitersubstrat, auf dem die Reaktand-Sorte abgeschieden ist, von dem beheizten Suszeptor und der Abscheidungskammer in eine nichtoxidierende Umgebung und in einen Interlock-Bereich entnommen werden, um das Abkühlen des Halbleitersubstrats zu gestatten; und
- der Suszeptor die Abscheidungskammer zwischen aufeinanderfolgenden Epitaxieabscheidungszyklen gereinigt werden.

2. Verfahren nach Anspruch 1, bei dem das Reinigen des Suszeptors und der Abscheidungkammer den Schritt umfaßt, daß zwischen den aufeinanderfolgenden Zyklen ein gasförmiges Ätzmittel in die Abscheidungskammer eingeführt wird, um jegliches der Reaktand-Halbleitersorte zu entfernen, die auf den Suszeptor und der Abscheidungskammer abgeschieden worden ist.

3. Verfahren nach Anspruch 1, bei der der Schritt, den aufgeheizten Suszeptor bei Temperaturen oberhalb von 600°C zu halten, den Schritt umfaßt, daß der Suszeptor und das Substrat auf eine Temperatur im Bereich von etwa 1150°C bis etwa 1200°C aufgeheizt werden.

4. Verfahren nach Anspruch 1, umfassend den Schritt, daß das Halbleitersubstrat mit einem Ätzgas geätzt wird, um durch Strömen von mit durch HCl dotiertem Wasserstoffgas über das Halbleitersubstrat mit einer Rate von etwa 60 bis etwa 100 Standardlitern pro Minute Verunreinigungen aus dem Halbleitersubstrat zu entfernen.

5. Verfahren nach Anspruch 4, bei dem der Schritt des Ätzens des Substrats weiter den Schritt umfaßt, daß Wasserstoffgas vorgesehen wird, in dem etwa 0,3 bis etwa 1,5 Volumenprozent HCl eindotiert sind.

6. Verfahren nach Anspruch 1, bei dem der Schritt dem Strömens eines Gasstroms einer Reaktand-Halbleitersorte in die Abscheidungskammer weiter den Schritt umfaßt, daß SiHCl₃ in die Abscheidungskammer und über die Halbleitersubstratoberfläche strömt.

7. Verfahren nach Anspruch 6, bei dem der Schritt des Strömens von SiHCl₃ in die Abscheidungskammer weiter den Schritt umfaßt, daß SiHCl₃ bei einer Rate von etwa 12 bis etwa 20 g/Minute in die Abscheidungskammer strömt.

8. Verfahren nach Anspruch 1, weiter umfassend die Schritte, daß:
- die Abscheidungskammer gegen einen Halbleitersubstratbehandlungsbereich der Reaktionskammer verschlossen wird;
- ein Ätzgas in die Abscheidungskammer in einem Trägergas strömt, während die Abscheidungskammer auf eine Temperatur größer als die Abscheidungstemperatur aufgeheizt wird;
- der Suszeptor und die Abscheidungskammer mit dem Ätzgas geätzt werden, um im wesentlichen die gesamte darauf abgeschiedene Reaktand-Halbleitersorte zu entfernen; und
- die Abscheidungskammer von dem Umgebungsätzgas gereinigt wird, während der Suszeptor und die Abscheidungskammer gleichzeitig abgekühlt werden, wodurch die Abscheidungskammer für einen nachfolgenden Abscheidungslauf vorbereitet wird.

9. Verfahren nach Anspruch 8, bei dem der Schritt des Strömens eines Ätzgases weiter den Schritt umfaßt, daß mit HCl dotiertes Wasserstoffgag bei einer Rate von etwa 20 Standardlitern pro Minute in die Abscheidungskammer strömt.

10. Verfahren nach Anspruch 9, bei dem der Schritt des Ätzens des Suszeptors und der Abscheidungskammer weiter den Schritt umfaßt, daß Wasserstoffgas vorgesehen wird, in dem etwa 0,3 bis etwa 1,5 Volumenprozent HCl eindotiert sind.

11. Verfahren nach Anspruch 10, bei dem der Schritt des Strömens eines Ätzgases weiter die Schritte umfaßt, daß der Suszeptor mit mit HCl dotiertem Wasserstoffgas, das mit etwa 20 Standardlitern pro Minute strömt, geätzt wird und anschließend die Strömung von mit HCl dotiertem Wasserstoffgas auf etwa 100 Standardliter pro Minute erhöht wird, um die Abscheidungskammer zu ätzen.

## Revendications

1. Procédé pour cycles répétitifs successifs de dépôt épitaxial de silicium dans une chambre de dépôt d'une chambre de réaction contenant un support chauffé, comprenant les étapes selon lesquelles :
- on maintient ledit support chauffé à des températures supérieures à 600°C pendant et entre chacun desdits cycles répétitifs successifs,
- on charge un substrat semi-conducteur sur ledit support chauffé à une température de chargement située entre les limites d'environ 600°C à 1000°C,
- on chauffe ledit support et ledit substrat à une température supérieure à ladite température de chargement,
- on fait circuler un courant gazeux d'une espèce semi-conductrice réactante dans ladite chambre de réaction pour obtenir la croissance épitaxiale de ladite espèce semi-conductrice réactante sur ledit substrat semi-conducteur,
- on refroidit ledit support et ledit substrat,
- on décharge ledit substrat semi-conducteur, sur lequel est déposée ladite espèce réactante, dudit support chauffé et de ladite chambre de dépôt dans un environnement non-oxydant et dans une région de sécurité pour permettre le refroidissement dudit substrat semi-conducteur et
- on nettoie ledit support et ladite chambre de dépôt entre les cycles de dépôt épitaxial successifs.

2. Procédé selon la revendication 1, dans lequel le nettoyage dudit support et de ladite chambre de dépôt comprend l'étape selon laquelle on introduit un élément corrosif gazeux dans ladite chambre de dépôt entre lesdits cycles répétitifs afin d'enlever tout desdites espèces semi-conductrices réactantes déposées sur ledit support et ladite chambre de dépôt.

3. Procédé selon la revendication 1, dans lequel l'étape selon laquelle on maintient ledit support chauffé à une température supérieure à 600°C comprend l'étape selon laquelle on chauffe le support et le substrat à une température comprise dans les limites d'environ 1150°C à environ 1200°C.

4. Procédé selon la revendication 1, comprenant l'étape selon laquelle on attaque le substrat semi-conducteur avec un gaz corrosif pour éliminer les impuretés dudit substrat semi-conducteur en faisant circuler du gaz hydrogène dopé à HCl sur le substrat semi-conducteur à une vitesse d'environ 60 à environ 100 litres normaux par minute.

5. Procédé selon la revendication 4, dans lequel l'étape selon laquelle on attaque le substrat comprend l'étape selon laquelle on utilise du gaz hydrogène ayant environ 0,3 à environ 1,5 % en volume de HCl dopé dans celui-ci.

6. Procédé selon la revendication 1, dans lequel l'étape selon laquelle on fait circuler un courant gazeux d'une espèce semi-conductrice réactante dans la chambre de dépôt comprend en outre l'étape selon laquelle on fait circuler du SiHCl₃ dans la chambre de dépôt et sur la surface du substrat semi-conducteur.

7. Procédé selon la revendication 6, dans lequel l'étape selon laquelle on fait circuler du SiHCl₃ dans la chambre de dépôt comprend en outre l'étape selon laquelle on fait circuler le SiHCl₃ dans la chambre de dépôt à une vitesse d'environ 12 à environ 20 g/min.

8. Procédé selon la revendication 1, comprenant en outre les étapes selon lesquelles :
- on isole la chambre de dépôt d'une zone de la chambre de réaction traitant un substrat semi-conducteur,
- on fait circuler un gaz corrosif dans la chambre de dépôt dans un gaz véhicule tout en chauffant la chambre de dépôt à une température supérieure à la température de dépôt,
- on attaque ledit support et ladite chambre de dépôt avec un gaz corrosif pour éliminer sensiblement toutes les espàces semi-conductrices réactantes déposées sur ceux-ci et
- on purge la chambre de dépôt du gaz corrosif ambiant tout en refroidissant simultanément le support et la chambre de dépôt, préparant aussi la chambre de dépôt pour un cycle de dépôt suivant.

9. Procédé selon la revendication 8, dans lequel l'étape selon laquelle on fait circuler un gaz corrosif comprend en outre l'étape selon laquelle on fait circuler du gaz hydrogène dopé à HCl dans la chambre de dépôt à une vitesse d'environ 20 litres normaux par minute.

10. Procédé selon la revendication 9, dans laquelle l'étape selon laquelle on attaque le support et la chambre de dépôt comprend l'étape selon laquelle on utilise du gaz hydrogène ayant environ 0,3 à environ 1,5 % en valeur de HCl dopé dans celui-ci.

11. Procédé selon la revendication 10 dans lequel l'étape selon laquelle on fait circuler un gaz corrosif comprend en outre les étapes selon lesquelles on attaque ledit support avec du gaz hydrogène dopé à HCl circulant à environ 20 litres nominaux par minute et ensuite on augmente le débit de gaz hydrogène dopé à HCl jusqu'à environ 100 litres normaux par minute pour attaquer la chambre de dépôt.
